# EUROPÄISCHE PATENTSCHRIFT

(11) **EP 0 513 715 B1**
(45) Veröffentlichungstag und Bekanntmachung des Hinweises auf die Patenterteilung: **26.07.2000**
(21) Anmeldenummer: 92107909.1
(22) Anmeldetag: 11.05.1992
(51) Int. Cl.: H01L 23/522, H01L 23/528

(54) **Leitbahnanorndung für höchstintegrierte Schaltungen**
Wiring arrangement for highly integrated circuits
Arrangement de lignes conductrices pour circuits à haute intégration

(30) Priorität: 15.05.1991 DE 4115909
(43) Veröffentlichungstag der Anmeldung: 19.11.1992
(73) Patentinhaber: SIEMENS AKTIENGESELLSCHAFT, 80333 München (DE)
(72) Erfinder: Savignac, Dominique, Dr,, W-8045 Ismaning (DE); Menke, Manfred, W-8000 München 81 (DE); Kohlhase, Armin, Dr., W-8012 Ottobrunn (DE); Melzner, Hanno, Wappinger Falls, NY 12590 (US)

(56) Entgegenhaltungen:
- EP-A- 0 414 412
- US-A- 4 827 449
- PROCCEEDINGS OF THE IEEE INTERNATIONAL ELECTRON DEVICES MEETING 83 5. Dezember 1983, NEW YORK , US Seiten 542 - 545; R.M.GEFFKEN: 'Multi-level metallurgy for master image structured logic'
- IBM TECHNICAL DISCLOSURE BULLETIN. Bd. 31, Nr. 10, März 1989, NEW YORK US Seiten 202 - 203; 'Method of contacting conductors through contact holes'
- IBM TECHNICAL DISCLOSURE BULLETIN. Bd. 30, Nr. 9, Februar 1988, NEW YORK US Seiten 381 - 382; 'Vias for chip wiring'

## Beschreibung

Die Erfindung betrifft eine Leitbahnanordnung für höchstintegrierte Schaltungen mit mindestens Zwei, im wesentlichen in einer ersten Richtung verlaufenden unteren Leitbahnen, und mindestens Zwei darüberliegenden, in der ersten Richtung verlaufenden oberen Leitbahnen.

In höchstintegrierten Schaltungen sollen Leitbahnen zur Ansteuerung bestimmter Zellen einen möglichst geringen elektrischen Widerstand aufweisen. Oft ist es jedoch aus verschiedenen, insbesondere verfahrenstechnischen Gründen nicht möglich, die Leitbahnen aus einem ausreichend niederohmigen Material herzustellen; ein Beispiel hierfür sind die im allgemeinen aus polykristallinen Silizium-Bahnen bestehenden Wortleitungen einer Halbleiterspeicheranordnung in einem aus Silizium bestehenden Halbleitersubstrat. Zur Verringerung des elektrischen Widerstandes ist es daher üblich, die Wortleitung mit einer darüberliegenden Aluminiumbahn an bestimmten Stellen zu kontaktieren ( s. bspw. Siemens Technical Information 1Mbit DRAM, No. B2-B3643-X-X-7600). Diese Stellen liegen im allgemeinen außerhalb der in Feldern angeordneten Speicherzellen, und zwar als sogenannte Verdrahtungsfelder jeweils zwischen zwei Zellenfeldern.

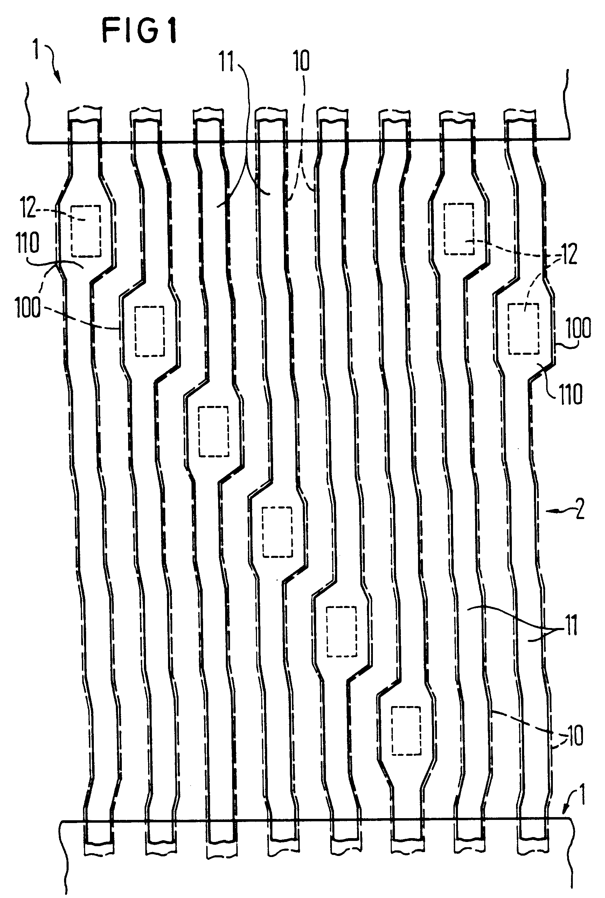

Figur 1 zeigt einen, bezüglich seiner Gesamtoffenbarung anmelderinternen, bis zum Prioritätstag der Öffentlichkeit nicht zugänglich gemachten Stand der Technik, nämlich eine Aufsicht auf einen Ausschnitt eines solchen Verdrahtungsfelds 2 zwischen den Zellenfeldern 1 mit einer konventionellen Anordnung von Polysilizium-Wortleitungen 10 (untere Leitbahnen), Aluminium-Wortleitungen 11 (obere Leitbahnen) und den Kontakten 12 zwischen jeweils einer Polysilizium-Wortleitung und einer darüberliegenden Aluminium-Wortleitung. Außerhalb der Kontakte 12 sind die untere und die obere Leitbahn durch eine isolierende Schicht elektrisch voneinander isoliert. In einem Verdrahtungsfeld 2 wird jede untere Leitbahn 10 über genau einen Kontakt 12 mit einer oberen Leitbahn 11 dadurch verbunden, daß vor Bildung der oberen Leitbahn 11 an dieser Stelle ein Kontaktloch 12 bspw. durch einen Ätzprozeß in der isolierenden Schicht hergestellt wird. An dem Kontakt 12 muß die untere Leitbahn 10 wegen einer möglichen Dejustierung des Kontaktlochs 12 gegenüber der unteren Leitbahn 10 zu einer Kontaktfläche 100 verbreitert werden, gleichzeitig soll das Leitbahn-Raster möglichst klein sein und insbesondere dem Leitbahn-Raster über dem Zellenfeld 1 entsprechen. Im allgemeinen wird auch die obere Leitbahn 11 zu einer Kontaktfläche 110 verbreitert. Die in Figur 1 gezeigte Anordnung der Kontakte 12 in einer sechsfachen Staffelung (d.h. die Kontakte von benachbarten Leitbahnen sind gegeneinander versetzt, wobei sich das Schema nach sechs Leitbahnen wiederholt), die spezielle Form der Kontaktflächen 100,110 und die gewellte (d.h. im wesentlichen geradlinige) Führung der Leitbahnen 10, 11 sind bereits auf diese Anforderungen hin weitgehend optimiert.

In dem Verdrahtungsfeld 2 sind in weiter unterliegenden Schichten im allgemeinen andere elektrisch relevante Strukturen angeordnet, bei Halbleiterspeicheranordnungen meist eine Polysilizium-Schicht, welche mit einer Elektrode der Speicherkondensatoren verbunden ist (sogenannte Polysilizium-Platte). Ist die mögliche Dejustierung der Kontakte 12 größer oder gleich der an der Kontaktfläche 100 erzielten Verbreiterung an der entsprechenden Seite der unteren Leitbahn 10, besteht die Gefahr, daß das Kontaktloch neben der Kontaktfläche bis zur unterliegenden Polysilizium-Platte geätzt wird. Nach Bildung der oberen Leitbahn 11 besteht dann an dieser Stelle ein zum Funktionsausfall führender Kurzschluß zur Polysilizium-Platte. Einer Vergrößerung der Kontaktfläche 100 der unteren Leitbahn steht ein erforderlicher Minimalabstand zwischen benachbarten unteren Leitbahnen und die phototechnisch erzielbare Strukturfeinheit entgegen.

In der US-PS 4 827 449 wird das Problem behandelt, bei einer Anordnung von unteren Wortleitungen und oberen Wortleitungen, die zwecks Widerstandsreduzierung miteinander kontaktiert sind, und bei der das Minimalraster der oberen Wortleitungen größer ist als das der unteren, den Platzbedarf zu senken. Insbesondere soll die gesamte Anordnung im Minimalraster der unteren Wortleitungen realisiert werden. Zur Lösung ist vorgesehen, die unteren Wortleitungen durchgehend anzulegen und die oberen Wortleitungen in Abschnitte zu unterteilen, wobei sich die Abschnitte benachbarter Wortleitungen der Länge nach nicht überlappen. Jeder Abschnitt wird über zwei an seinen Enden angeordnete Kontakte mit der zugehörigen untere Wortleitung verbunden, so daß jede untere Wortleitung abschnittsweise mit einer oberen Leitung parallel geschaltet ist. Dadurch, daß sich benachbarte Abschnitte in Längsrichtung nicht überlappen, ist das Raster in der oberen Wortleitungsebene doppelt so groß wie in der unteren. Allerdings kann der Gesamtwiderstand höchstens auf die Hälfte einer unteren Wortleitung gesenkt werden. Ferner ist die Anordnung sehr empfindlich gegenüber Justierfehlern bei der Kontakterzeugung, da die unteren Wortleitungen aufgrund des Minimalrasters keine Kontaktflächen aufweisen können.

In dem Artikel Proc. of IEEE IEDM, Dez. 83, S.542 - 545 wird eine Mehrlagenverdrahtung in einer Halbleiterschaltung beschrieben, bei der eine hohe Prozeßsicherheit - d.h. Unempfindlichkeit gegenüber Justierfehlern bei der Erzeugung der Kontakte zwischen den Verdrahtungsebenen - auch ohne die Verwendung von Kontaktflächen erreicht wird. Dazu wird als Intermetalldielektrikum ein Isolator eingesetzt, der selektiv ätzbar ist zu dem Untergrund, auf dem die untere Verdrahtungsebene angeordnet ist. Für die Strukturierung der oberen Leitbahnebene wird ein Lift-off-Prozeß eingesetzt.

Der vorliegenden Erfindung liegt daher die Aufgabe zugrunde, die unteren und oberen Leitbahnen und die Kontakte dazwischen so anzuordnen, daß sie bei geringem Platzbedarf in hohem Maße unempfindlich gegenüber einer Dejustierung von unteren Leitbahnen, Kontaktlöchern und oberen Leitbahnen gegeneinander sind.

Diese Aufgabe wird durch eine Anordnung gemäß Patentanspruch 1 gelöst. Weiterbildungen der Erfindung sind Gegenstand von Unteransprüchen.

Die Erfindung wird im folgenden anhand von in den Zeichnungen dargestellten Ausführungsbeispielen näher erläutert. In den Figuren sind gleiche Teile mit gleichen Bezugsziffern bezeichnet. Es zeigen:
- Figur 1: eine Aufsicht auf eine dem Anmelder eigenen, internen Stand der Technik entsprechende Anordnung von unteren und oberen Leitbahnen in einem Verdrahtungsfeld in schematischer Darstellung,
- Figur 2 und 3: zwei Ausführungsformen der erfinderischen Leitbahnanordnung.

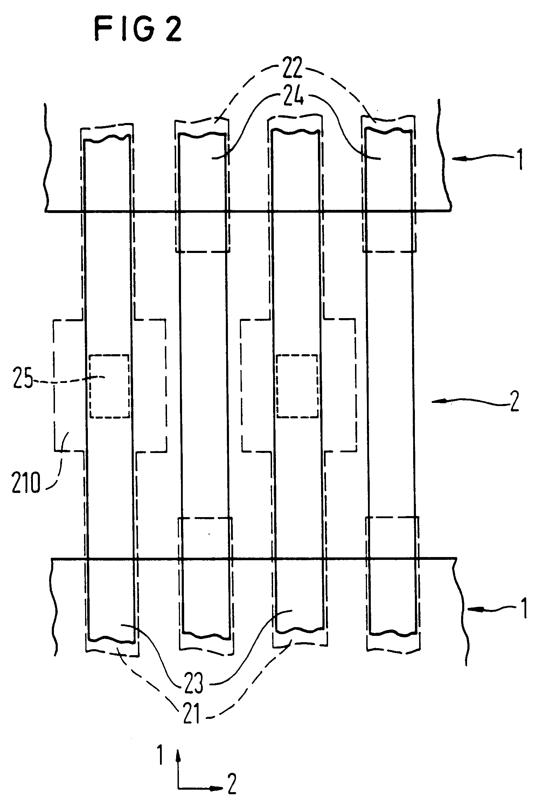

Figur 2: Die Aufsicht auf einen Ausschnitt eines Verdrahtungsfeldes 2 zwischen zwei Zellenfeldern 1 zeigt in einer ersten Richtung verlaufende untere Leitbahnen 21, 22 (gestrichelt gezeichnet) und darüberliegende obere Leitbahnen 23, 24. Erfindungsgemäß ist in einem Verdrahtungsfeld 2 jede zweite (bei Abzählung gerade) untere Leitbahn 22 unterteilt, d.h. sie besitzt eine Lücke. Die in der zweiten, zur ersten senkrechten Richtung benachbarte untere Leitbahn 21 (ungerade Leitbahn) ist in diesem Verdrahtungsfeld durchgehend angelegt und besitzt eine Kontaktfläche 210 in der Nähe der Lücke. Dieses Muster von ungeraden unteren Leitbahnen 21 mit der Kontaktfläche 210 und geraden unteren Leitbahnen 22 mit der Lücke wird in der zweiten Richtung periodisch wiederholt. Die oberen Leitbahnen 23,24 verlaufen geradlinig darüber, wobei am Ort der Kontaktfläche 210 ein Kontakt 25 zur unteren Leitbahn besteht, der auf konventionelle Weise, wie bei Figur 1 beschrieben, hergestellt werden kann. In einem Verdrahtungsfeld 2 wird also nur jede zweite obere Leitbahn 23 mit jeder zweiten unteren Leitbahn 21 kontaktiert, d.h. nur zwischen den ungeraden unteren und oberen Leitbahnen besteht ein Kontakt 25. In dem in der ersten Richtung folgenden Verdrahtungsfeld, welches durch das Zellenfeld 1 von dem in der Figur dargestellten Verdrahtungsfeld 2 getrennt ist, sind die geraden unteren Leitbahnen 22 durchgehend angelegt und besitzen einen Kontakt zur jeweils überliegenden geraden oberen Leitbahn 24. Entsprechend besitzen dort in der Nähe eines solchen Kontaktes die ungeraden unteren Leitbahnen 21 eine Lücke.

Erfindungsgemäß wird jede untere Leitbahn 21, 22 also in Abschnitten angelegt, die durch Lücken voneinander getrennt sind. Jeder Abschnitt verläuft dabei in dieser Ausführungsform über zwei Zellenfelder und das dazwischenliegende Verdrahtungsfeld. Im dazwischenliegenden Verdrahtungsfeld besitzt der Abschnitt einen Kontakt zur überliegenden oberen Leitbahn. In den beiden sich an die erwähnten Zellenfelder anschließenden (außenliegenden) Verdrahtungsfeldern sind die den Abschnitt beendenden Lücken angeordnet. Die in der zweiten Richtung benachbarte untere Leitbahn besitzt in dem dazwischenliegenden Verdrahtungsfeld mindestens in der Nähe des erwähnten Kontaktes eine Lücke zwischen zwei Abschnitten, in den außen liegenden Verdrahtungsfeldern besitzt jeder dieser Abschnitte einen Kontakt.

Aufgrund der Lücken können die Kontaktflächen 210 der jeweils durchgehenden unteren Leitbahnen ausreichend groß dimensioniert werden, so daß auch bei der größten anzunehmenden Dejustierung des Kontaktlochs 25 gegenüber der unteren Leitbahn 21 das Kontaktloch noch im Bereich der Kontaktfläche 210 liegt. Ein Anätzen der Umgebung und ein eventueller Kurzschluß zu unterliegenden Strukturen kann ausgeschlossen werden. Die Lücke einer unteren Leitbahn kann sich über das gesamte Verdrahtungsfeld 2 erstrecken.

Aufgrund der fest vorgegebenen maximalen Laufzeit über eine untere Leitbahn zwischen einer Zelle im Zellenfeld und dem Kontakt darf die Ausdehnung eines Zellenfeldes in der ersten Richtung bei der erfinderischen Leitbahn-Anordnung nur halb so groß sein wie bei der konventionellen Anordnung, da jede Zelle nur auf einer Seite des Zellenfeldes einen Kontakt zu einer oberen Leitbahn besitzt. Entsprechend sind statt n Verdrahtungsfeldern bei konventioneller Anordnung 2n + 1 Verdrahtungsfelder bei der erfinderischen Anordnung nötig. Dafür kann die Ausdehnung eines Verdrahtungsfeldes in der ersten Richtung je nach Ausführungsform der Erfindung stark reduziert werden, da nur jede zweite Leitbahn eine Kontaktfläche aufweist und auf eine Staffelung eventuell völlig verzichtet werden kann. Der tatsächliche Platzbedarf ist insbesondere abhängig vom vorgegebenen Leitbahnraster und von der erzielbaren Strukturfeinheit. Die erfindungsgemäße Anordnung ist besonders vorteilhaft bei sehr engen Leitbahn-Rastern, bspw. bei einem 64M DRAM, einsetzbar.

Durch die erfindungsgemäße Anordnung der Leitbahnen ändern sich die elektrischen Parameter gegenüber der konventionellen Anordnung nicht, da die effektive Länge einer unteren Leitbahn gleich groß bleibt. Auch die Fehlerrate aufgrund eines defekten Kontaktes ändert sich nicht. Sowohl bei der konventionellen als auch bei der erfinderischen Anordnung ist ein Ausfall mindestens der betroffenen Zellen die Folge, da im konventionellen Fall für die Zellen in der Nähe des defekten oder fehlenden Kontaktes die Laufzeit über die untere Leitbahn um einen Faktor 4 größer wird und ein Signal nicht mehr rechtzeitig gelesen werden kann.

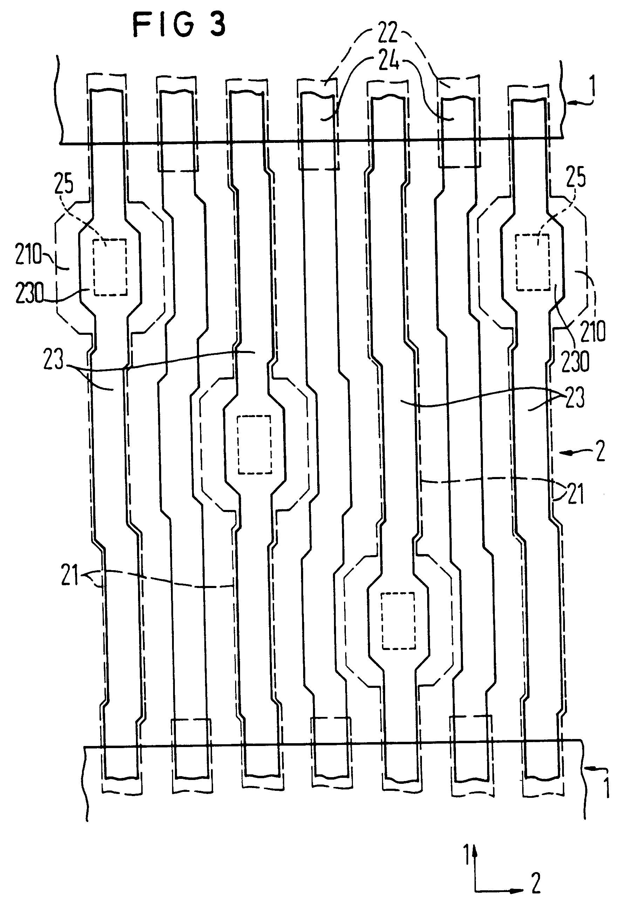

Figur 3: In der dargestellten Ausführungsform werden die Merkmale der Erfindung vorteilhaft kombiniert mit einer Staffelung der Kontakte und einem gewellten Verlauf der Leitbahnen. Es ist eine dreifache Staffelung dargestellt, so daß sich das Muster nach sechs Leitbahnen wiederholt. In diesem Ausführungsbeispiel sind auch die oberen Leitbahnen 23 zu Kontaktflächen 230 verbreitert.

Diese Anordnung gewährt auch bei großen Justierfehlern zuverlässige Kontakte: Beispielsweise beträgt das Leitbahn-Raster 1,4 µm (Leitbahn-Breite und -Abstand je 0,7 µm), die Kontaktfläche einer unteren Leitbahn 2,3 µm × 2,8 µm, das Kontaktloch 25 0,7 µm × 1,2 µm. Das Kontaktloch 25 kann also in jeder der vier Richtungen um 0,8 µm dejustiert sein, ohne Über die untere Kontaktfläche 210 hinauszuragen. Da Justierfehler dieser Größe praktisch auszuschließen sind, können die unteren Kontaktflächen im allgemeinen kleiner gewählt werden, wodurch die Anordnung einen geringeren Platzbedarf aufweist. Die oberen Kontaktflächen 230 sind 1,3 µm × 2,1 µm groß, d.h. bei einer Dejustierung von 0,3 µm in der zweiten und 0,45 µm in der ersten Richtung werden die Kontaktlöcher 25 noch voll überdeckt. Der Abstand zwischen zwei oberen Leitbahnen beträgt überall mindestens 0,7 µm.

## Patentansprüche

1. Leitbahnanordnung in einer höchstintegrierten Schaltung auf einem Halbleitersubstrat mit mindestens zwei, im wesentlichen in einer ersten Richtung verlaufenden unteren Leitbahnen (21, 22), und mindestens zwei darüberliegenden, im wesentlichen in der ersten Richtung verlaufenden oberen Leitbahnen (23, 24), mit folgenden Merkmalen:
- die Schaltung weist eine Folge von Zellenfeldern (1) und Verdrahtungsfeldern (2) auf, die in der ersten Richtung alternierend angeordnet sind,
- die unteren(21,22) und die oberen Leitbahnen (23,24) überlappen sich jeweils vertikal und sind durch eine isolierende Schicht voneinander getrennt,
- jede untere Leitbahn verläuft über die Folge von Zellenfeldern (1) und Verdrahtungsfeldern (2) und ist in Abschnitte unterteilt mit zwischen den Abschnitten liegenden Lücken, wobei ein Abschnitt sich über zwei Zellenfelder und ein dazwischenliegendes Verdrahtungsfeld erstreckt und Lücken über Verdrahtungsfeldern angeordnet sind,
- jeder Abschnitt besitzt genau einen Kontakt zur dar überliegenden durchgehenden oberen Leitbahn, der in einem Verdrahtungsfeld angeordnet ist, wobei die untere Leitbahn im Bereich des Kontaktes zu einer Kontaktfläche (210) verbreitert ist,
- in einer zweiten, zur ersten senkrechten Richtung ausgehend von einer Kontaktfläche (210) besitzt die benachbarte untere Leitbahn jeweils eine der oben genannten Lücken.

2. Leitbahnanordnung nach Anspruch 1,
**gekennzeichnet durch** eine periodische Wiederholung der Anordnung in der zweiten Richtung.

3. Leitbahnanordnung nach einem der Ansprüche 1 bis 2,
**dadurch gekennzeichnet,** daß die Lücke sich über den überwiegenden Teil des Verdrahtungsfeldes (2) erstreckt.

4. Leitbahnanordnung nach einem der Ansprüche 1 bis 3,
**dadurch gekennzeichnet,** daß die oberen Leitbahnen im Bereich der Kontakte zu Kontaktflächen (230) verbreitert sind.

5. Leitbahnanordnung nach einem der Ansprüche 1 bis 4,
**dadurch gekennzeichnet,** daß in der zweiten Richtung benachbarte Kontakte in der ersten Richtung gegeneinander versetzt angeordnet sind.

6. Leitbahnanordnung nach Anspruch 5**, dadurch gekennzeichnet,** daß die unteren (21,22) und oberen Leitbahnen (23,24) in der Umgebung eines in der zweiten Richtung benachbarten Kontaktes eine jeweils vom Kontakt wegweisende Ausbuchtung entlang der zweiten Richtung aufweisen.

## Claims

1. Interconnect arrangement in a very large scale integrated circuit on a semiconductor substrate with at least two lower interconnects (21, 22) running essentially in a first direction, and at least two upper interconnects (23, 24) running essentially in the first direction and lying above the former, having the following features:
- the circuit has a sequence of cell arrays (1) and wiring arrays (2), which are arranged alternately in the first direction,
- the lower (21, 22) and the upper interconnects (23, 24) overlap vertically in each case and are isolated from one another by an insulating layer,
- each lower interconnect runs over the sequence of cell arrays (1) and wiring arrays (2) and is subdivided into sections with gaps between the sections, a section extending over two cell arrays and an intervening wiring array and gaps being arranged over wiring arrays,
- each section has precisely one contact with the continuous upper interconnect lying above it, the said contact being arranged in a wiring array, the lower interconnect being widened in the region of the contact to form a contact area (210),
- in a second direction, perpendicular to the first, proceeding from a contact area (210), the neighbouring lower interconnect in each case has one of the abovementioned gaps.

2. Interconnect arrangement according to Claim 1, characterized by a periodic repetition of the arrangement in the second direction.

3. Interconnect arrangement according to Claims 1 to 2, characterized in that the gap extends over the predominant part of the wiring array (2).

4. Interconnect arrangement according to one of Claims 1 to 3, characterized in that the upper interconnects are widened in the region of the contacts to form contact areas (230).

5. Interconnect arrangement according to one of Claims 1 to 4, characterized in that neighbouring contacts in the second direction are arranged such that they are offset relative to one another in the first direction.

6. Interconnect arrangement according to Claim 5, characterized in that the lower (21, 22) and upper interconnects (23, 24), in the vicinity of a neighbouring contact in the second direction, have a bulge respectively pointing away from the contact along the second direction.

## Revendications

1. Arrangement de pistes conductrices dans un circuit à très grande densité d'intégration sur un substrat semi-conducteur, comportant au moins deux pistes (21, 22) conductrices inférieures s'étendant sensiblement dans une première direction et au moins deux pistes (23, 24) conductrices supérieures qui se trouvent au-dessus et qui s'étendent sensiblement dans la première direction, et ayant les caractéristiques suivantes :
- le circuit comporte une succession de champs (1) de cellule et de champs (2) de câblage qui sont montés en alternance dans la première direction,
- les pistes (21, 22) conductrices inférieures et les pistes (23, 24) conductrices supérieures se chevauchent chaque fois verticalement et sont séparées les unes des autres par une couche isolante,
- chaque piste conductrice inférieure s'étend sur la succession de champs (1) de cellule et de champs (2) de câblage et est subdivisée en tronçons comportant des vides se trouvant entre les tronçons, un tronçon s'étendant sur deux champs de cellule et un champ de câblage entre ces deux champs, et des vides étant disposés sur des champs de câblage,
- chaque tronçon a exactement un contact avec la piste conductrice supérieure continue qui se trouve au-dessus et qui est montée dans un champ de câblage, la piste conductrice inférieure étant élargie en une surface (210) de contact dans la zone du contact,
- la piste conductrice inférieure voisine a, dans une deuxième direction perpendiculaire à la première, à partir d'une surface (210) de contact, chaque fois l'un des vides mentionnés ci-dessus.

2. Arrangement de pistes conductrices suivant la revendication 1, caractérisé par une répétition périodique de l'arrangement dans la deuxième direction.

3. Arrangement de pistes conductrices suivant l'une des revendications 1 à 2, caractérisé en ce que le vide s'étend sur la plus grande partie du champ (2) de câblage.

4. Arrangement de pistes conductrices suivant l'une des revendications 1 à 3, caractérisé en ce que les pistes conductrices supérieures sont élargies en surface (230) de contact dans la zone des contacts.

5. Arrangement de pistes conductrices suivant l'une des revendications 1 à 4, caractérisé en ce que des contacts voisins dans la deuxième direction sont montés en étant décalés les uns par rapport aux autres dans la première direction.

6. Arrangement de pistes conductrices suivant la revendication 5, caractérisé en ce que les pistes (21, 22) conductrices inférieures et les pistes (23, 24) conductrices supérieures ont à proximité d'un contact voisin dans la deuxième direction, le long de la deuxième direction, chaque fois une indentation qui pointe en s'éloignant du contact.
